Europäisches Patentamt

**European Patent Office**

**Office européen des brevets**

(11) Publication number: **0 130 845**
**B1**

(12) **EUROPEAN PATENT SPECIFICATION**

(45) Date of publication of patent specification: **03.01.90**

(51) Int. Cl.⁵: **H 01 R 23/68, H 05 K 7/02,**
**H 01 R 13/66, H 05 K 3/30**

(21) Application number: **84304577.4**

(22) Date of filing: **04.07.84**

(54) Interconnection apparatus for wiring harnesses.

(30) Priority: **05.07.83 JP 122642/83**

(43) Date of publication of application:
**09.01.85 Bulletin 85/02**

(45) Publication of the grant of the patent:
**03.01.90 Bulletin 90/01**

(84) Designated Contracting States:
**DE FR GB**

(56) References cited:
**DE-A-1 615 596**
**US-A-3 963 301**
**US-A-4 133 592**

(73) Proprietor: **Sumitomo Wiring Systems, Ltd.**
**1-14, Nishisuehirocho**
**Yokkaichi-shi Mie-ken (JP)**

(73) Proprietor: **SUMITOMO ELECTRIC INDUSTRIES**
**LIMITED**
**No. 15, Kitahama 5-chome Higashi-ku**
**Osaka-shi Osaka 541 (JP)**

(72) Inventor: **Ito, Mitsuru**
**2343-2 Wakatakecho**
**Kuwana-shi (JP)**

(74) Representative: **Topps, Ronald et al**
**D. YOUNG & CO 10 Staple Inn**
**London WC1V 7RD (GB)**

Courier Press, Leamington Spa, England.

## Description

The present invention relates to improvements in and relating to an interconnection apparatus for wiring harnesses particularly those in which a busbar is arranged to form a large number of branch conductive paths and the electric cables of a wiring harness are connected to the branch conductive paths thereby providing a large number of branch circuits.

With a conventional wiring harness used for wiring the body of an automobile, it is necessary to provide a large number of branch circuits in the midst of the wiring harness and an interconnection apparatus for wiring harnesses (hereinafter simply referred to as an interconnection apparatus) is known in which a plurality of branch conductive paths corresponding to the previously mentioned wiring harness branch circuits are integrally formed on an electric wiring board by the arrangement of a busbar and the cables of a wiring harness are connected to the branch conductive paths thereby concentrically providing the desired branch circuits.

On the other hand, in order to ensure the functioning of the branch circuits, the wiring harness is required to arrange the required elements for the branch circuits, e.g., groups of functional components such as relays, diodes, capacitors and timers and incorporate these circuits in the branch circuits.

Thus, arrangements are in use in which these functional components are concentrated and accommodated in a casing for each branch circuit and the casings are mounted on an interconnection apparatus thereby incorporating them in the midst of the branch conductive paths or alternatively in the case of a time control unit a power window timer and a power window control, for example, the required functional component groups are separately grouped and mounted at various points on the vehicle body and are connected to the interconnection apparatus through the wiring harness.

With the recent sophistication of automobiles, however, the number of branch circuits of a wiring harness has been increased and also there has been a notable tendency toward incorporating a large number of functional components in each branch circuit thus giving rise to a need for making smaller and more compact the whole construction of the wiring harness system and the interconnection apparatus. Also, working elements such as relays which are operable mechanically and electronic elements which include no mechanically operable parts have been included in the same group and this gives rises to a maintenance problem in that the electronic elements having much longer lives than the working elements have to be replaced simultaneously with the working elements having shorter lives.

According to the present invention there is provided an apparatus which interconnects branch circuit means of a wiring harness and functional component circuit means, comprising: a wiring board including a busbar arrangement forming a branch conductive path;

printed-circuit boards mounted on said wiring board and including a plurality of functional components forming said functional component circuit means;

said busbar arrangement of said wiring board including tab contacts at end portions thereof;

said printed-circuit boards including a plurality of sheet terminals lying flat along the boards adjacent edges thereof and connected to a respective plurality of said tab contacts;

a plurality of tab terminals mounted on one of said printed-circuit boards; and

common connecting means whereby a further plurality of said tab contacts and said tab terminals on one printed-circuit board are connected to said branch circuit means.

In the preferred embodiments of the invention, the functional components groups to be incorporated in the branch circuits of a wiring harness are separated into a working element group and an electronic element group which are respectively arranged on two different printed-circuit boards, and the printed-circuit board of the working element group and the printed-circuit board of the electronic element group are respectively mounted on the upper and lower surfaces of an interconnection apparatus in such a manner that the conductive paths of the two printed-circuit boards are connected to the branch conductive paths of the interconnection apparatus thereby incorporating the functional component circuits in the branch circuits of the wiring harness.

It should be mentioned as background prior art that US Patent US-A-4,133,592 discloses a printed-circuit board system comprising at least three parallel spaced printed-circuit boards having conductive contact receiving means positioned on both surfaces of each board, predetermined ones of said contact receiving means on one side of a board being electrically connected to said contact receiving means on the other side of the same board by means of a conductor positioned in an aperture passing through said board.

An embodiment of the invention will now be described, by way of an example, with reference to the accompanying drawings, in which:

Figure 1 is a perspective view showing the top side of an interconnection apparatus according to an embodiment of the invention;

Figure 2 is a perspective view showing the back side of the embodiment shown in Figure 1;

Figure 3 is a front view showing the connection between a conductive path of a printed-circuit board and a busbar in the embodiment of Figure 1; and

Figure 4 is a front view showing a connecting mechanism in the view shown in Figure 2.

The present invention will now be described in greater detail with reference to the illustrated embodiment.

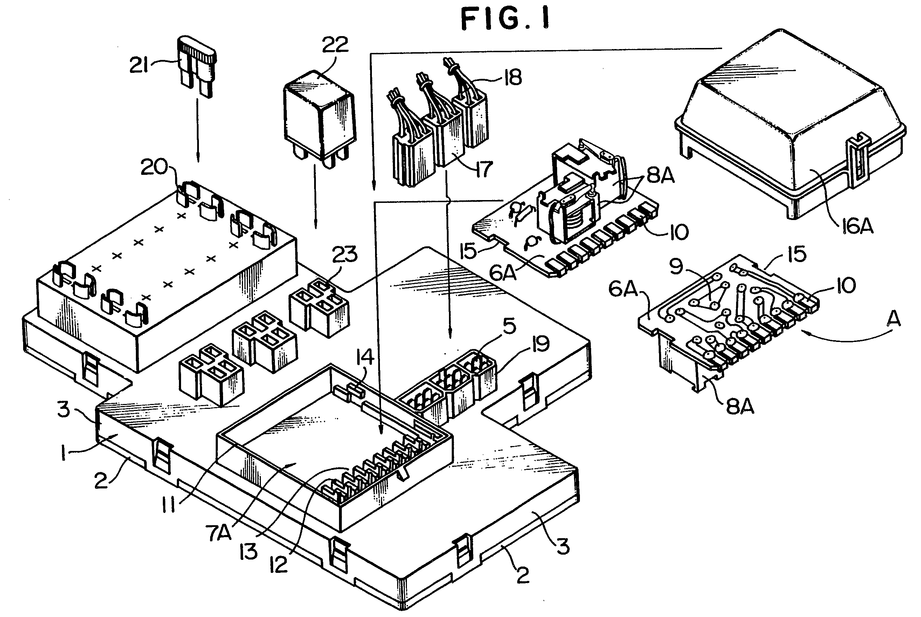

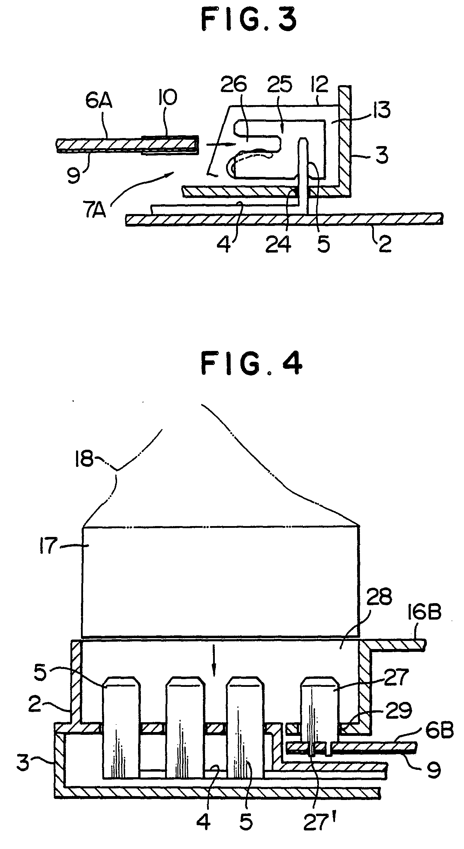

Referring to Figures 1 to 4, an interconnection apparatus 1 of this invention includes a plate wiring board 2 of insulating material and an upper cover 3 which are combined as a unit. A busbar arrangement 4 (Figures 3 and 4) is arranged on the wiring board 2 to centrally form the required branch circuits for a wiring harness and the ends of the busbar arrangement 4 are provided with tab contact members 5 (partly shown) extending perpendicularly from the wiring board 2 to project through the upper cover 3 or project downwardly of the wiring board 2 for connection with the conductive paths of printed-circuit boards which will be described later or a connector 17 at the end of a bunch of cables 18 of the wiring harness. Also, formed on the upper surface of the upper cover 3 is a reception chamber 7A for receiving a printed-circuit board 6A, the reception chamber 7A having a bottom which is square in shape and being enclosed by a frame member 11 for receiving the printed-circuit board 6A from above with termal receiving pockets 13 defined by partition walls 12 being arranged in parallel on the front bottom portion. Of the functional components of the wiring harness, there is only a single group of working elements 8A such as relays forming working means, these elements being arranged together on one level on the upper surface of the printed-circuit board 6A. Also, conductive paths 9 for the working elements 8A are formed by printed wiring on the back surface of the printed-circuit board 6A as shown at A in Fig. 1 and terminals 10 are grippingly attached side by side to the edge portion of one side edge of the printed-circuit board 6A so as to be electrically connected to the conductive paths 9. The terminals 10 and the busbar end are interconnected in the following manner. Referring to Fig. 3, one of the tab contact members 5 at the end portion of the busbar 4 projects through each tab inserting hole 24 of the upper cover 3 and an intermediate terminal 25 is fitted on the tab contact member 5. The arrangement is such that when the printed-circuit board 6A is inserted from above into the reception chamber 7A as shown in Fig. 1 and then slightly slid forwardly the terminals 10 arranged side by side at the side edge of the printed-circuit board 6A are each engaged with a respective slot contact portion 26 of an intermediate terminal 25 in one of the pockets 13 as shown in Fig. 3 so that the conductive paths 9 of the printed-circuit board 6A are connected to the busbar 4 and the functional component circuit of the operating element group 8A are incorporated in the branch circuits of the busbar 4. It is to be noted that the insertion of the printed-circuit board 6A is allowed by the engagement of a pair of notches 15 formed at its opposed side edges with a pair of engaging projections 14 on the side edges of the reception chamber 7A and that the printed-circuit board 6A is held in place by the pair of engaging projections 14 when it is slid forward so that it is detachably held in place.

Also, fuse mounts 20 for the respective branch circuits are provided on the upper surface of the upper cover 3 and a two-leg fuse 21 is fitted in each of the fuse mounts 20. In addition, there are provided connector mounts 19 each including tab contact members 5, and connectors 17 provided at the end of bunches of cables 18 are received in the connector mounts 19 thereby connecting the branch circuits provided by the busbar 4 to the wiring harness. In Figure 1, numeral 16A designates a cover for the reception chamber 7A which, after the insertion of the printed-circuit board 6A, is placed over the working element group 8A to cover and protect it. In the Figure, numeral 22 designates a housing containing an externally fitted relay which must be replaced periodically and numeral 23 designates mounts for the relay.

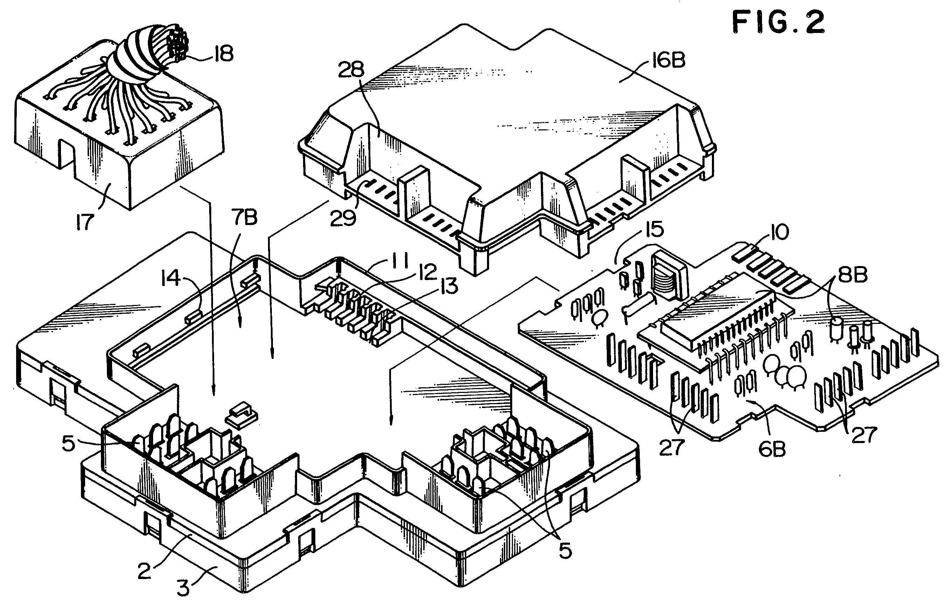

Referring now to Figure 2, a reception chamber 7B enclosed by a wall member 11 is formed on the back surface of the wiring board 2 and it is constructed such that of the required functional components of the wiring harness there is only a single group of control elements 8B such as a controller, timer etc., forming a control unit, these elements being arranged together on a printed-circuit board 6B by for example the technique of automatic electronic component packaging and this printed-circuit board 6B is received so as to connect the conductive paths of the printed-circuit board 6B to the tab contact members 5 at the ends of the busbar 4 and incorporate the conductive paths of the control element group 8B in the branch circuits of the busbar 4. As a result, the reception chamber 7B and the printed-circuit board 6B are respectively the same in construction as the reception chamber 7A and the printed-circuit board 6A, that is, the reception chamber 7B is provided at its one side edge with a plurality of receiving pockets 13 defined side by side by partition walls 12 to receive intermediate terminals 25 and the printed-circuit board 6B is provided with similar conductive paths to those of the printed-circuit board 6A on its back surface and terminals 10 arranged side by side at one side edge with the conductive paths being connected to the busbar 4 by the same connection arrangement as shown in Fig. 3.

Referring further to Figs. 2 and 4, the printed-circuit board 6B is provided at other side edges with perpendicularly mounted tab terminals 27 for connection with the conductive paths 9 on the back surface, and the tab contact members 5 at the end of the busbar 4 extend perpendicularly from the portions of the wiring board 2 which are adjacent to the side edges of the reception chamber 7B. Also, connecting mechanisms are provided so that when the printed-circuit board 6B is inserted in the reception chamber 7B, the tab contact members 5 and the tab terminals 27 form groups of contacts for receiving a connector 17 at the end of a bunch of cables 18. More specifically, the printed-circuit board 6B is provided at its side edges with the tab terminals 27 perpendicularly arranged side by side and each including a small leg piece 27' extending through the back surface, the small leg pieces 27' being soldered to the conductive paths 9. Also, a cover 16B for covering the printed-circuit board 6B is formed with recesses 28 at its side edges and holes 29 for receiving the tab terminals 27 are formed through the bottom of the recesses 28. Thus, when the printed-circuit board 6B is inserted into the reception chamber 7B and then the cover 16B is placed over the former, the tab terminals 27 project through the holes 29 and together with the tab contact members 5 projecting from the wiring board 2 form groups of contacts. The connector 17 at the end of the bunch of wiring harness cables 18 forms a common connector thereby directly connecting the functional component circuits of the printed-circuit board 6B to the wiring harness through the connector 17 and not through the busbar 4 of the wiring board 2.

As described hereinabove, the functional component circuits of the group of electronic elements 8B on the printed-circuit board 6B are connected to the circuits of the group of working elements 8A by the printed-circuit board 6A through the busbar 4 or they are connected to the connector 17. Thus, the functional component circuits of the printed-circuit boards 6A and 6B are incorporated in the branch circuits of the wiring harness.

In the above-described interconnection apparatus of the present invention, functional component groups to be incorporated in the branch circuits of a wiring harness are grouped on the printed-circuit boards of the interconnection apparatus in such a manner that the functional component groups are divided into two classes, i.e. a control element group and a working element group which are gathered together at one level on the separate printed-circuit boards 6A and 6B, respectively and they are then mounted in a three-dimentional manner on the upper and lower surfaces of a wiring board 2 formed with branch conductive paths by the arrangement of a busbar. As a result, the wiring harness system is made more compact and smaller as compared with the conventional construction in which functional component groups are formed into separate groups for the respective unit electric equipment, mounted at various places on the vehicle body and connected to a wiring harness.

The integration of the functional component groups on the plurality of printed-circuit boards has the effect of increasing the freedom of arrangement and construction of the interconnection apparatus as a whole and makes possible the selection of a compact shape.

Further, by virtue of the fact that the working element groups which require frequent replacement are arranged, along with the other replacement components such as fuses, on the upper surface of the interconnection apparatus and the control element groups which do not require frequent replacement are accommodated on the lower surface of the interconnection apparatus, the maintenance of these element groups is considerably facilitated and loss of a useful control element due to its being replaced and discarded with a working element is prevented.

Further, since the above-mentioned connection mechanisms utilizing the connector 17 as a common connector allows the direct connection of a part of the functional component circuits of the printed-circuit board 6B to the wiring harness instead of connection to the busbar arrangement 4, the busbar arrangement 4 on the wiring board 2 is simplified and also the single connector allows both the connection of the branch circuits to the busbar arrangement 4 and the connection and incorporation of the functional component circuits thereby decreasing the number of the connectors in the interconnection apparatus and making the interconnection apparatus more compact and smaller in size. Still further, since the connecting operation is effected collectively as compared with the conventional means of connecting the terminals of the printed-circuit board 6B to the tab contact members 5 at the ends of the busbar arrangement 4, there is the advantage of simplifying the connecting operation and reducing the danger of occurrence of malfunctions such as contact failure.

It is to be noted that the above-mentioned connecting mechanisms are applicable not only to the layered arrangement of the functional components in the above-described embodiment but also to an interconnection apparatus employing printed-circuit boards each incorporating both control and functional element groups and it is possible to enjoy the previously mentioned effects.

From the foregoing description it will be seen that the present invention provides an interconnection apparatus which meets the need for a more compact wiring harness as required by the sophistication of automobiles.

**Claims**

1. An apparatus which interconnects branch circuit means of a wiring harness and functional component circuit means, comprising:
   a wiring board (2) including a busbar arrangement (4) forming a branch conductive path;
   printed-circuit boards (6A, 6B) mounted on said wiring board (2) and including a plurality of functional components (8A, 8B) forming said functional component circuit means;
   said busbar arrangement (4) of said wiring board (2) including tab contacts (5) at end portions thereof;
   said printed-circuit boards (6A, 6B) including a plurality of sheet terminals (10) lying flat along the boards adjacent edges thereof and connected to a respective plurality of said tab contacts (5);
   a plurality of tab terminals (27) mounted on one of said printed-circuit boards (6B); and
   common connecting means (17) whereby a further plurality of said tab contacts (5) and said tab terminals (27) on one printed-circuit board (6B) are connected to said branch circuit means.

2. An apparatus as claimed in claim 1 in which said busbar arrangement (4) of said wiring board (2) includes a plurality of tab contacts (5) connected to said branch circuit means of said wiring harness (18).

3. An apparatus as claimed in claim 1 or claim 2 in which each of said printed-circuit boards (6A, 6B) includes at least one of a plurality of flat sheet terminals (10) connected to said tab contacts (5) of said busbar arrangement (4) and a plurality of tab terminals (27) connected to said functional component circuit means and directly connected to said branch circuit means.

## Patentansprüche

1. Vorrichtung, die Abzweigkreise eines Kabelbaumes und Funktionskomponentenkreise miteinander verbindet, enthaltend:
eine Verdrahtungsplatte (2) mit einer Sammelschienenanordnung (4), die einen Abzweigleitungsweg bildet;
Druckschaltkarten (6A, 6B), die auf der Verdrahtungsplatte (2) befestigt sind und die mehrere Funktionskomponenten (8A, 8B) enthalten, die die Funktionskomponentenkreise bilden;
wobei die Sammelschienenanordnung (4) und die Verdrahtungsplatte (2) Zungenkontakte (5) an ihren Endabschnitten aufweisen,
die Druckschaltkarten (6A, 6B) mehrere Anschlußflecken (10) aufweisen, die flach längs der Ränder benachbart deren Kanten liegen und mit einer entsprechenden Vielzahl von Zungenkontakten (5) verbunden sind;
mehrere Zungenanschlüsse (27), die auf einer der Druckschaltkarten (6B) befestigt sind; und
eine gemeinsame Verbindungseinrichtung (17), durch die eine weitere Vielzahl der genannten Zungenkontakte (5) und Zungenanschlüsse (27) auf einer Druckschaltkarte (6B) mit den Abzweigkreisen verbunden sind.

2. Vorrichtung nach Anspruch 1, bei der die genannte Sammelschienenanordnung (4) der Verdrahtungsplatte (2) mehrere Zungenkontakte (5) enthält, die mit den Abzweigkreisen des Kabelbaumes (18) verbunden sind.

3. Vorrichtung nach Anspruch 1 oder 2, bei der jede der Druckschaltkarten (6A, 6B) wenigstens einen aus einer Vielzahl von Anschlußflecken (10) enthält, die mit den Zungenkontakten (5) der Sammelschienenanordnung (4) verbunden sind, und eine Vielzahl von Zungenanschlüssen (27), die mit den Funktionskomponentenkreisen verbunden sind und direkt mit den Abzweigkreisen verbunden sind.

## Revendications

1. Appareil d'interconnexion de dispositifs à circuits de branchement d'un faisceau de câblage et de dispositifs à circuits de composants fonctionnels, comprenant:
une carte de câblage (2) comprenant un ensemble à barre omnibus (4) formant un trajet conducteur de branchement,
des cartes de circuit imprimé (6A, 6B) montées sur la carte de câblage (2) et comprenant plusieurs composants fonctionnels (8A, 8B) formant les dispositifs à circuits de composants fonctionnels,
l'ensemble à barre omnibus (4) de la carte de câblage (2) comprenant des contacts (5) en forme de pattes à ses parties d'extrémité,
les cartes de circuit imprimé (6A, 6B) comprenant plusieurs bornes, (10) en forme de feuille placées à plat le long de bords adjacents des cartes et connectées à plusieurs contacts respectifs (5) en forme de pattes,
plusieurs bornes (27) en forme de pattes montées sur l'une des cartes de circuit imprimé (6B), et
un dispositif commun de connexion (17), grâce auquel un ensemble supplémentaire de contacts (5) en forme de pattes et les bornes (27) en forme de pattes de ladite une des cartes de circuit imprimé (6B) sont connectés aux dispositifs à circuits de branchement.

2. Appareil selon la revendication 1, dans lequel l'ensemble à barre omnibus (4) de la carte de câblage (2) comporte plusieurs contacts (5) en forme de pattes connectés aux dispositifs à circuits de branchement du faisceau de câblage (18).

3. Appareil selon la revendication 1 ou 2, dans lequel chacune des cartes de circuit imprimé (6A, 6B) comporte au moins l'une de plusieurs bornes (10) sous forme d'une feuille plate, connectée aux contacts en forme de pattes (5) de l'ensemble à barre omnibus (4), et plusieurs bornes (27) en forme de pattes connectées aux dispositifs à circuits de composants fonctionnels et directement connectées aux dispositifs à circuits de branchement.

FIG. I

FIG.2

# FIG.3

# FIG.4